# EUROPEAN PATENT SPECIFICATION

(11) **EP 1 602 623 B1**
(45) Date of publication and mention of the grant of the patent: **17.08.2011**
(21) Application number: 04717813.2
(22) Date of filing: 05.03.2004
(51) Int. Cl.: B81B 1/00, B81C 99/00

(54) **Method of moulding a microfluidic structure and mould**
Verfahren zum Abformen einer mikrofluidischen Struktur und Form
Procédé pour mouler des structures microfluidiques et moule

(30) Priority: 07.03.2003 JP 2003061640
(43) Date of publication of application: 07.12.2005
(73) Proprietor: TOSOH CORPORATION, Shunan-shi Yamaguchi-ken 746-8501 (JP)
(72) Inventor: KAWAI, Akira, Sagamihara-shi, Kanagawa 228-0804 (JP); HARA, Katsuyuki, Chigasaki-shi, Kanagawa 253-0082 (JP); KATAYAMA, Koji, Yamato-shi, Kanagawa-ken (JP); FUTAMI, Toru, Yokohama-shi, Kanagawa 240-0044 (JP)
(74) Representative: Bentz, Jean-Paul
(86) International application number: PCT/JP2004/002805
(87) International publication number: WO 2004/078639

(56) References cited:
- WO-A-98/45693
- WO-A1-03/006221
- JP-A- 7 211 603
- JP-A- 7 211 603
- JP-A- 2001 519 907
- JP-A- 2002 225 266
- JP-A- 2002 370 232
- JP-A- 2002 370 232
- JP-U- 4 128 818
- JP-U- 61 109 710
- US-A- 4 551 084
- US-A- 5 932 315
- US-A1- 2002 176 804

## Description

### BACKGROUND OF THE INVENTION

### Field of the Invention

The present invention relates to a fine channel device and a mold.

### Description of Related Art

In recent years, much attention has been focused on research using fine channel devices, wherein fine channels with a length of several cm, and a width and depth within a range from the sub-micron level to several hundreds of µm are formed on top of a square glass substrate with a side dimension of several cm, and these fine channel devices are then used for conducting chemical and physical operations such as chemical reactions, chemical syntheses, analysis, separation, and extraction (for example, see H. Hisamoto et al., Fast and high conversion phase-transfer synthesis exploiting the liquid-liquid interface formed in a microchannel chip, Chem. Commun., 2001, pp. 2662 to 2663), or for producing fine particles such as chromatography fillers or microcapsules (for example, see International Patent Application, No. WO02/068104). In this description, the term fine channel refers to a space with a width of no more than 500 µm and a depth of no more than 100 µm.

In addition, research is also being conducted into enabling fine channel devices to be applied to industrial mass production, by layering a plurality of fine channel devices (for example, see Japanese Unexamined Patent Application, First Publication No.

In the example listed above, a series of fine channel substrates each include fluid inlet portions for reaction raw material fluids (A) and (B) and a reaction product fluid discharge portion (in other words, through holes), as well as a fine channel with a width of several tens of µm to several hundreds of µm that interconnects with the through holes and functions as the reaction zone, formed on top of a flat glass substrate formed from Pyrex (a registered trademark) glass or the like. A predetermined number of these fine channel substrates are then laminated together to form a single integrated unit, thereby enabling mass production. Moreover, by integrating a predetermined number of these fine channel substrate laminated units within a single parallel arrangement, even larger industrial scale mass production can be made possible.

In order to form the fine channels with widths of several tens of µm to several hundreds of µm within these fine channel substrates, typically, a conventional technique such as wet etching is used. Furthermore, formation of the fluid inlet portions and fluid discharge portions is achieved using a general mechanical processing technique. However, these conventional methods are far from simple, and formation of the fine channels requires a plurality of steps, including steps for exposure, developing, and wet etching. Similarly, formation of the through holes that correspond with the fluid inlet portions and the fluid discharge portion also requires a plurality of steps, including steps for bonding, processing, and stripping.

As described above, by laminating a plurality of fine channel substrates into a single integrated unit, and then arranging a plurality of these laminated integrated units in parallel, mass production of chromatography fillers or microcapsules or the like can be carried out. However, the production of large numbers of fine channel substrates requires considerable time and cost. Furthermore, if each fine channel substrate is formed with a high density of fine channels, for example 100 to 200 channels, then the number of through holes corresponding with the fluid inlet portions and the fluid discharge portions increases significantly, resulting in further increases in cost.

In order to reduce costs, tests are being conducted into forming fine channel devices containing fine channels from resins. This can be achieved by replacing the Pyrex glass substrate or the like used in the above example with a resin substrate. A resin substrate containing fine channels can be prepared using conventional techniques such as molding. In addition, if continuous molding techniques such as injection molding are used, then further cost reductions should be possible.

The formation of the fluid inlet portions and fluid discharge portions in this type of resin fine channel substrate can be achieved using typical mechanical processing, in a similar manner to that used with glass materials such as Pyrex glass. Furthermore, as described above, by laminating a plurality of fine channel substrates into a single integrated unit, and then arranging a plurality of these laminated integrated units in parallel, industrial mass production becomes possible. However, the preparation of large quantities of fine channel substrates requires considerable time and cost. For example, if each fine channel substrate is formed with a high density of fine channels, for example 100 to 200 channels, then the number of through holes corresponding with the fluid inlet portions and the fluid discharge portions increases significantly. This causes further increases in cost, meaning any cost savings achieved by altering the material used for the fine channel substrate from a glass materials such as Pyrex glass to a resin material are halved or even lost altogether.

The through holes in a fine channel substrate are typically formed using a mechanical technique such as drilling, blast processing, ultrasound drilling or the like. However, this can cause burrs and the like around the hole openings or on the internal walls of the holes, meaning a favorable level of surface roughness cannot be achieved. In such cases, if fine particles with sizes that fall within a range from several nm to approximately 1 µm are generated and then discharged through the holes, the above burrs and the like can cause deformation of the shape of the particles, and/or fine particles may also catch on the side walls, chocking the holes and preventing discharge of the generated fine particles.

Published International patent application WO03/006221 discloses an injection moulding technique for creating a microfluidic substrate comprising through-holes. The mould which is described in the document comprises two platens, one platen carrying a stamper having convex portions for forming concave fine channels as well as removable tapered pins inserted in holes. Ejector pins built in the mould are used to remove the moulded article.

The present invention is proposed in light of the conventional circumstances described above, with an object of providing a method for producing a fine channel substrate, wherein concave portions that correspond with fine channels for channeling fluids, and through holes for either introducing or discharging fluids, are formed in a single molding operation, and the concave portions corresponding with the fine channels and the through holes are interconnected, as well as a fine channel device produced using such a method.

### SUMMARY OF THE INVENTION

A first aspect of the present invention is a mold, which includes pins for forming the through holes in the fine channel substrate, in accordance with claim 1 A second aspect of the invention is a method in accordance with claim 5.

### BRIEF DESCRIPTION OF THE DRAWINGS

FIG. 1 is a schematic view showing the main components of an injection molding device for producing a fine channel substrate of the present invention.
FIG. 2 is a schematic cross-sectional view showing the structure of the mold of an injection molding device for producing a fine channel substrate of the present invention.
FIG. 3A is a schematic cross-sectional view showing the primary clamping operation for the injection mold that is used for producing a fine channel substrate of the present invention.
FIG. 3B is a schematic cross-sectional view showing the secondary clamping operation for the mold.
FIG. 3C is a schematic cross-sectional view showing the operation for opening the mold.
FIG. 3D is a schematic cross-sectional view showing the state following completion of the mold opening operation.
FIG. 4 is a schematic plan view showing a fine channel substrate of the present invention.

### DETAILED DESCRIPTION OF THE INVENTION

Fine channel substrates can be used for conducting chemical and physical operations such as chemical reactions, chemical syntheses, analysis, separation and extraction, or for producing fine particles such as chromatography fillers or microcapsules within the fine channels. The present invention relates to a member used for producing such a substrate and a producing method thereof.

In order to resolve the problems described above, the present invention is used to provide a fine channel device, wherein fine channels and through holes are provided in a fine channel substrate, the fine channels and the through holes are interconnected via interconnection portions, and fluids are able to flow without chocking.

Furthermore, in those cases where two or more fluids are used to generate particles such as droplets or solid particles inside a fine channel, the cross-sectional area of the interconnection portion is larger than the maximum cross-sectional area in the flow direction of the particles such as solid particles or droplets contained within the fluid (that is, the maximum value of the cross-sectional area when a particle such as a droplet is cut perpendicularly to the long axis of the channel). Furthermore, the roughness of at least one of, and preferably all of, the substrate surface of the fine channel, the internal walls of the fine channel, and the internal walls of the through holes, preferably satisfy Ra < 10 nm, and even more preferably 0.2 nm < Ra < 8 nm, and most preferably 0.2 nm < Ra < 2 nm. In the present invention, measurement of the surface roughness is conducted using the dynamic mode of an atomic force microscope. Furthermore, by providing a superior mold, which functions as a member for forming fine channel substrates and fine channel devices, and a superior production method that uses the mold to enable the fine channels and through holes to be formed in a single molding operation, the present invention is able to resolve the problems associated with the conventional technology described above, and the inventors were thus able to complete the present invention. As follows is a more detailed description of the present invention.

The fine channel device contains a fine channel substrate that includes a fine channel for flowing fluids, and through holes, wherein the fine channel and the through holes are interconnected via interconnection portions.

These interconnection portions are structures which allow fluid to flow without chocking. In a preferred configuration, the surface roughness of the fine channel substrate, including the substrate surface inside the fine channel, the internal walls of the fine channel, and the internal walls of the through holes, satisfies Ra < 10 nm. By using this type of configuration, effects such as those described below can be achieved. In this description, an interconnection portion describes the portion where the fluid flowing through a fine channel changes flow direction upon entering a through hole, and in a structural sense, refers to the intersection portion between the fine channel and the through hole, and the surrounding area. Furthermore, a structure with an interconnection portion that is described as enabling a fluid to flow without chocking refers to a structure in which the fluid or droplets are able to flow smoothly through the fine channel, which means either fluid flowing through the fine channel without chocking, or droplets and the like flowing through the fine channel without undergoing deformation or separation.

A fine channel device is generally formed by bonding a cover, in which through holes corresponding with the fluid inlet holes and discharge holes have been formed at predetermined locations, on top of a substrate in which the fine channels have been formed. In such cases, positional displacement can occur between the fine channels and the through holes when the cover is bonded to the fine channel substrate, and/or obstruction of the interconnection portions between the fine channels and the through holes is caused. Using a fine channel device such as that disclosed here , where the fine channels and the through holes are formed on a single substrate, removes the requirement for forming through holes in a cover, thereby enabling the prevention of any positional displacement between the fine channels and the through holes and obstruction of the interconnection portions between the fine channels and the through holes.

Furthermore, generally, when a fine channel and a through hole are interconnected, provided the cross-sectional open-area ratio of the interconnection portion between the fine channel and the through hole (if the entire cross-section of the interconnection portion is open, this value is 100%) is larger than the cross-sectional area of the particles such as solids or droplets contained within the fluid, then the fluid will not become blocked within the fine channel, and droplets will not undergo deformation or separation within the fine channel. For example, if a fluid that contains no solid particles having cross-sectional area either equal to or greater than 20% of the cross-sectional area of the interconnection portion between the fine channel and the through hole is fed through the fine channel of a fine channel device, then provided the cross-sectional area at the interconnection portion between the fine channel and the through hole exhibits an open-area ratio of at least 20%, the fluid that contains no solid particles of cross-sectional area 20% or greater can be channeled satisfactorily through the fine channel.

Furthermore, a fine channel device as defined herein may include convex portions near the sides of the fine channels. In addition, the fine channel device may be formed using a fine channel substrate that includes convex portions near the sides of the through holes. Using such structures means that when a fine channel substrate and a cover are bonded together, the degree of air tightness at the contact surface between the fine channels, the through holes, and the cover can be improved: This type of structure is particularly useful in those cases where the fine channel substrate and the cover are bonded by crimping together.

Furthermore, a fine channel device of the present invention may also be formed from a fine channel substrate containing one or more orientation flats. When mass production of a substance is conducted using a fine channel device, a series of fine channel devices are generally laminated together to form a single integrated unit. In such cases, in order to enable a fluid such as a gas or a liquid to be introduced into each individual fine channel device within the laminated unit, and enable the fluid such as a gas or a liquid to be discharged from each individual fine channel device, a fine channel device is used in which through holes are also formed in the cover. The holes within the plurality of fine channel substrates must then be aligned with the holes in the plurality of covers. Accordingly, in order to effect this alignment, one or more orientation flats are preferably formed on each of the fine channel substrates. For example, two orientation flats could be formed at desired locations. If two orientation flats that intersect at right angles are formed, then positioning of the substrates can be further simplified.

The bonding of the fine channel substrate and the cover, or the bonding of two or more fine channel devices, can be conducted using typical methods, including the crimping described above, as well as thermal bonding, room temperature bonding, bonding via adhesives and the like. In the present invention, any of these methods can be used, depending on the circumstances.

Through holes are generally formed by mechanical processing and the like. However, in the case of through holes formed by mechanical processing and the like, suppressing the generation of small burrs and the like with sizes ranging from the sub-micron level to several microns can be difficult, and the surface roughness (Ra) of the through holes tends to be very poor. As a result, when droplets with a favorable particle size distribution that have been generated inside a fine channel pass through the through hole corresponding with the discharge hole, some droplets are sheared off by the small burrs, causing a worsening of the particle size distribution. In contrast, when a resin substrate is processed using a molding technique, and particularly injection molding, then in a similar manner to that seen in the production of optical disks and the like, the surface roughness (Ra) of the substrate can be suppressed to the sub-micron level. By employing this type of processing method optionally, the fine channels and through holes can be formed in a single molding operation, and by using injection molding as the molding method, the roughness (Ra) of the substrate surface inside the fine channels, the interval walls of the fine channels, and the internal walls of the through holes can be suppressed to less than 10 nm. Accordingly, the appearance of the types of small burrs with sizes ranging from the sub-micron level to several microns that are generated using mechanical processing techniques can be suppressed. Furthermore, when bonding a cover to a substrate or bonding fine channel devices together, it is preferable that the cover and/or the fine channel substrate are as flat as possible. For example, the surface in which the concave portions corresponding with the fine channels are formed should preferably not be curved, and/or should have a radius of curvature of at least 5 m and no more than 100 m.

The molding used in the present invention described above is preferably either cast molding or injection molding, and unless stated otherwise, refers to injection molding. Suitable resins are thermosetting resins and thermoplastic resins.

Furthermore, there are also no particular restrictions on the size of the fine channel substrate, including the surface area, the shape, and the substrate thickness. However, from the viewpoints of ensuring that the fine channel substrate is large enough to be handled easily during preparation, and being small enough to maintain the apparatus miniaturization benefits of a small size devices, the fine channel substrate is preferably a square shape with dimensions within a range from about several cm x several cm to no more than 20 cm x 20 cm, or a circular disc shape with a diameter within a range from about several cm to no more than 20 cm. Specifically, the shape is preferably a square of 5 cm x 5 cm to 20 cm x 20 cm, or a circular disc with a diameter of about 5 cm to 20 cm. The thickness of the fine channel substrate is preferably no more than several mm, and is preferably within a range from about 0.6 mm to 2.0 mm. Furthermore, there are no particular restrictions on the size of the through holes formed in the fine channel substrate of the present invention, although considering that the width of the fine channels is no more than 500 µm, through holes with a diameter of about several mm are preferred. Considering that the diameter of the capillary tubes or the like used for connecting the holes of the fluid inlet portion and the fluid discharge portion to an external feed pump or fluid recovery bottle is typically in the order of about several mm, a particularly preferred diameter for the through holes is within a range from about 0.5 to 2.0 mm.

Although a mold is used in most typical molding processes, the mold of the present invention also includes pins for forming the through holes in the fine channel substrate, and the positions of these pins and the number of pins can be altered as desired. The pins may be shaped so as to taper towards the tip. By using this type of configuration, any number of through holes can be formed at the desired locations within the cover, and each through hole no longer needs to be formed individually by mechanical processing, enabling the production costs for the fine channel substrate to be reduced.

On example of a configuration of the present invention that enables the positions of the pins and the number of pins to be altered as desired is described below. A mold is used that contains holes for mounting 150 pins, and pins are inserted only within those holes that correspond with those positions in which through holes are to be formed. Those holes that do not correspond with the position of a through hole are plugged with dummy pins. In this manner, the desired number of pins are positioned at the desired locations. The present invention is, of course, not limited to this configuration, and can use any configuration that enables the pin positions to be altered, provided the configuration does not depart from the scope of the present invention.

In the mold of the present invention, the pins are preferably shaped so as to taper towards the tip. By so doing, the fine channel substrate can be more easily taken off following formation of the through holes by molding.

Furthermore, a mold of the present invention includes pins for forming the through holes in the fine channel substrate, and convex portions for forming the fine channels, wherein the positions of the pins and the number of pins can be altered as desired. The pins are shaped so as to taper towards the tip. Furthermore, a method for producing a fine channel substrate according to the present invention uses this type of mold. By so doing, the fine channels and through holes can be formed in the fine channel substrate with a single molding operation. Furthermore, any number of through holes can be formed at desired locations in the fine channel substrate, and each individual through hole no longer needs to be formed by mechanical processing, enabling the production costs for the fine channel substrate to be reduced. Moreover, by using pins that taper towards the tip, the fine channel substrate can be more easily taken off following formation of the through holes by molding.

A method for producing a fine channel substrate according to the present invention is a method for producing, in a single double-sided molding operation, a fine channel substrate containing concave portions that correspond with fine channels, and through holes at desired locations in the fine channel substrate, wherein a mold equipped with pins for forming the through holes in the fine channel substrate, in which the positions of the pins and the number of pins can be altered as desired and the pins are shaped so as to taper towards the tip, is used on one side, and a mold containing convex portions corresponding with the fine channels is used on the opposite side.

The mold containing the convex portions corresponding with the fine channels is a stamper. By using such a configuration, the fine channels and the through holes can be formed in the fine channel substrate with a single molding operation. Furthermore, any number of through holes can be formed at desired locations in the fine channel substrate, and each through hole no longer needs to be formed individually by mechanical processing, enabling the production costs for the fine channel substrate to be reduced. Moreover, by using pins that taper towards the tip, the fine channel substrate can be more easily taken off following formation of the through holes by molding. Furthermore, by using a stamper for the mold that contains the convex portions corresponding with the fine channels, costs can be reduced even further than the case where the mold is processed directly to form the convex portions. In addition, if a variety of stampers are prepared in advance for fine channels of varying shapes, then the desired fine channel shape can be formed simply by exchanging the stamper.

Furthermore, in a method for producing a fine channel substrate according to the present invention, the molding operation may use injection molding. In a similar manner to that seen in the production of optical disks and the like, processing of resin substrates and the like using injection molding enables the surface roughness (Ra) of the substrate to be suppressed to the sub-micron level, and the roughness (Ra) of the substrate surface of the fine channels, the internal walls of the fine channels, and the internal walls of the through holes can be suppressed to less than 10 nm. Accordingly, the appearance of the types of small burrs and the like with sizes ranging from the sub-micron level to several microns that are generated using mechanical processing techniques can be suppressed. Furthermore, in order to enable favorable bonding of a cover, it is preferable that the fine channel substrate is as flat as possible. For example, the surface in which the concave portions corresponding with the fine channels are formed is formed as a curved shape with a center of curvature, and the associated radius of curvature can be set to a value of at least 5 m and no more than 100 m.

Furthermore, a method for producing a fine channel device according to the present invention is a method for producing a fine channel substrate that includes an ejector plate for enabling to take off the fine channel substrate easily from the mold that includes the pins for forming through holes at desired locations in the fine channel substrate. Continuous mass production of fine channel substrates only becomes possible when this type of function, enabling to take off the fine channel substrate easily from the mold, is provided.

As follows is a review of the details of the effects provided by the present invention.

The present invention is used to provide a fine channel device containing a fine channel substrate that includes fine channels for channeling fluids, and through holes, wherein the fine channels and the through holes are interconnected via interconnection portions, and the interconnection portions exhibit favorable transport properties. In a particularly preferred fine channel device, the roughness of the substrate surface of the fine channels, the internal walls of the fine channels, and the internal walls of the through holes, satisfy Ra < 10 nm. Using such a configuration removes the requirement for forming through holes in the cover, thereby enabling the prevention of any positional displacement between the fine channels and the through holes, and any obstruction of the interconnection portions between the fine channels and the through holes can be prevented.

Furthermore, generally, when a fine channel and a through hole are interconnected, provided the cross-sectional open-area ratio in the interconnection portion between the fine channel and the through hole is larger than the cross-sectional area of the particles such as solids or droplets contained within the fluid, then the fluid will not become choked within the fine channel, and droplets will not undergo deformation or separation within the fine channel.

In addition, a fine channel device made by using the present invention may include convex portions near the sides of the fine channels, and may be formed using a fine channel substrate that includes convex portions near the sides of the through holes. Using such a configuration means that when a fine channel substrate and a cover are bonded together, the degree of air tightness at the contact surface between the fine channels, the through holes, and the cover can be improved. This type of structure is particularly useful in those cases where the fine channel substrate and cover are crimped together.

Furthermore, a fine channel device made by the present invention may also be formed from a fine channel substrate containing one or more orientation flats. When mass production of a substance is conducted using a fine channel device, fine channel devices are generally laminated together to form a single integrated unit. In such cases, in order to enable a fluid to be introduced into each individual fine channel device within the laminated unit, and/or enable the fluid to be discharged from each individual fine channel device, a fine channel device is used in which through holes are also formed in the cover. The holes within the plurality of fine channel substrates must then be aligned with the holes in the plurality of covers. Accordingly, in order to effect this alignment, one or more orientation flats are preferably formed on each of the fine channel substrates. If two orientation flats that intersect at right angles are formed, then positioning of the substrates can be further simplified.

Moreover, a mold of the present invention includes pins for forming through holes in a fine channel substrate, and the positions of these pins and the number of pins can be altered as desired. Furthermore, the pins are shaped so as to taper towards the tip. By using this type of configuration, any number of through holes can be formed at desired locations in the cover, and each through hole no longer needs to be formed individually by mechanical processing, enabling the production costs for the fine channel substrate to be reduced.

A mold of the present invention contains pins that are shaped so as to taper towards the tip. By using such a configuration, the fine channel substrate can be more easily taken off following formation of the through holes by molding.

Furthermore, a mold of the present invention includes pins for forming the through holes in the fine channel substrate, and convex portions for forming the fine channels, wherein the positions of the pins and the number of pins can be altered as desired. Furthermore, the pins are shaped so as to taper towards the tip. A method for producing a fine channel substrate according to the present invention may use this type of mold. By so doing, the fine channels and through holes can be formed in the fine channel substrate with a single molding operation. Furthermore, any number of through holes can be formed at desired locations in the fine channel substrate, and each through hole no longer needs to be formed individually by mechanical processing, enabling the production costs for the fine channel substrate to be reduced. Moreover, by using pins that taper towards the tip, the fine channel substrate can be more easily taken off following formation of the through holes by molding.

A method for producing a fine channel substrate according to the present invention is a method for producing, in a single double-sided molding operation, a fine channel substrate containing concave portions that correspond with fine channels, and through holes at desired locations in the fine channel substrate, wherein a mold equipped with pins for forming the through holes in the fine channel substrate, in which the positions of the pins and the number of pins can be altered as desired and the pins are shaped so as to taper towards the tip, is used on one side, and a mold containing convex portions corresponding with the fine channels is used on the opposite side. The mold containing the convex portions corresponding with the fine channels is a stamper. By using such a method, the fine channels and the through holes can be formed in the fine channel substrate with a single molding operation. Furthermore, any number of through holes can be formed at desired locations in the fine channel substrate, and each through hole no longer needs to be formed individually by mechanical processing, enabling the production costs for the fine channel substrate to be reduced. Moreover, by using pins that taper towards the tip, the fine channel substrate can be more easily taken off following formation of the through holes by molding. Furthermore, by using a stamper for the mold that contains the convex portions corresponding with the fine channels, costs can be reduced even further than the case where the mold is processed directly to form the convex portions. In addition, if a variety of stampers are prepared in advance for fine channels of varying shapes, then the desired fine channel shape can be formed simply by exchanging the stamper.

Furthermore, a method for producing a fine channel substrate according to the present invention is a method in which the molding operation may use injection molding. In a similar manner to that seen in the production of optical disks and the like, processing of resin substrates and the like using injection molding enables the surface roughness (Ra) of the substrate to be suppressed to the sub-micron level, and the roughness (Ra) of the substrate surface inside the fine channels, the internal walls of the fine channels, and the internal walls of the through holes can be suppressed to less than 10 nm. Accordingly, the appearance of the types of small burrs or the like with sizes ranging from the sub-micron level to several microns that are generated using mechanical processing techniques can be suppressed. Furthermore, in order to enable favorable bonding of a cover, it is preferable that the fine channel substrate is as flat as possible. For example, the surface in which the concave portions corresponding with the fine channels are formed is formed as a curved shape with a center of curvature, and the radius of curvature can be set to a value of at least 5 m and no more than 100 m.

Furthermore, a method for producing a fine channel device according to the present invention is a method for producing a fine channel substrate that includes steps for enabling to take off the fine channel substrate easily from the mold that includes the pins for forming through holes at desired locations in the fine channel substrate. Continuous mass production of fine channel substrates only becomes possible when this type of function, enabling to take off the fine channel substrate easily from the mold, is provided.

As follows is a description of one embodiment of the present invention, based on the appended drawings. It should be understood that this embodiment is merely exemplary of the invention and is not to be considered as limiting. Various modifications can, of course, be made optionally without departing from the scope of the present invention as defined in the claims. Moreover, combinations of different elements of the example are also possible.

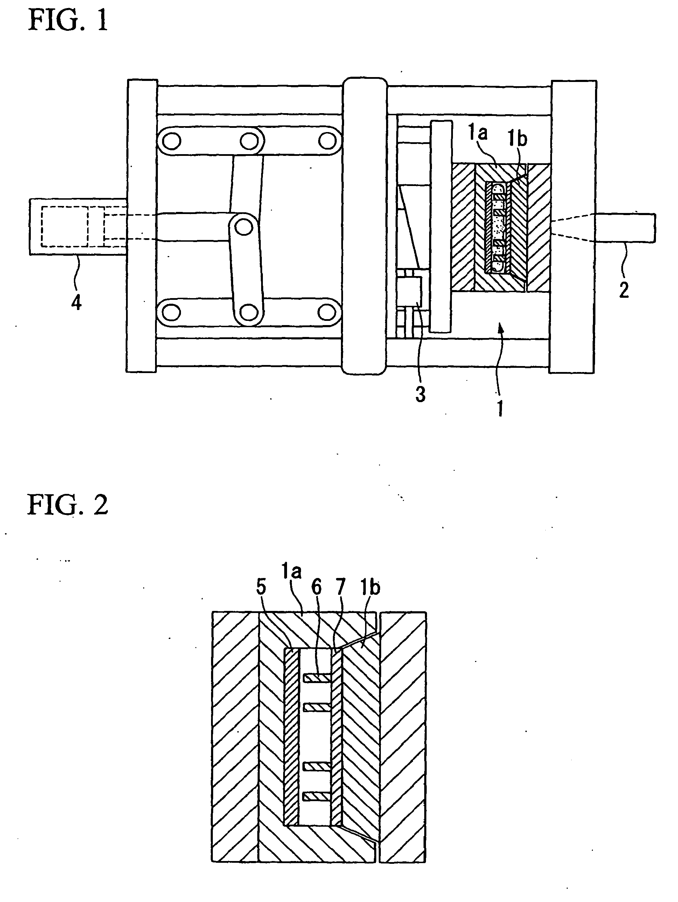

First, the main structural mechanisms of an injection molding device used for generating a thermoplastic resin fine channel substrate containing through holes and concave portions that correspond with the fine channels is described with reference to FIG 1. The injection molding device includes, as its main structural mechanisms, a mold 1 (including a movable mold 1a and a fixed mold 1b), an injection nozzle 2, a compression mechanism 3, and a clamping cylinder 4.

The device is described in more detail using FIG 2. In the fine channel substrate of the present invention, containing concave portions that correspond with the fine channels and through holes, a stamper 5 that contains convex portions that correspond with the fine channels is secured to the movable mold 1a, and pins 6 that form the through holes are secured to the fixed mold 1b by press fitting. The movable mold 1a to which the stamper 5 is secured is shaped so as to form orthogonal orientation flats in the injection molded substrate. In addition, a mold component, namely an ejector plate 7 used for a separation, is positioned on the mirror surface side of the fixed mold 1b into which the pins 6 have been inserted. The ejector plate 7 has holes in positions corresponding with the locations of the pins 6 so that the pins can slide through the ejector plate 7, and both the surface of the ejector that acts as the mirror surface for the fixed mold 1b, and the opposing surface are formed as mirror surfaces.

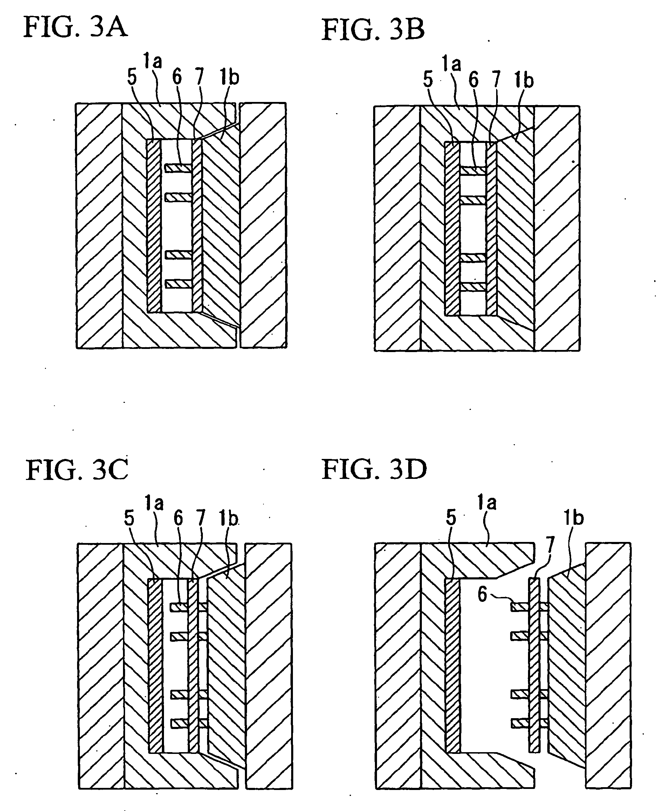

Next is a description of a method for producing a thermoplastic resin fine channel substrate containing concave portions that correspond with the fine channels and through holes, based on FIG 3A to FIG 3D. In this method, first, the clamping cylinder 4 is used to clamp the mold at a position that is larger than the thickness of the fine channel substrate (primary clamping, FIG 3A). Melted thermoplastic resin is then injected in through the injection nozzle 2, filling the cavity with the thermoplastic resin, and a compressive force is then applied by secondary clamping (FIG 3B) to obtain the correct thickness for the injection molded substrate. At this point, the shape of the convex portions that correspond with the fine channels are transferred, and the through holes are also formed. Subsequently, the compressed thermoplastic resin is cooled to a curing temperature, and the mold is then opened. As the mold is opened, the ejector plate 7 also moves slightly and sequentially (FIG 3C), thereby pushing the thermoplastic resin off the pins 6 used to form the through holes. At the same time, the slight movement of the ejector plate 7 causes the thermoplastic resin to remain on the side of the stamper 5 used for forming the fine channels, thus enabling the mold opening operation to be completed (FIG 3D). Spool cutting or an ejector pin is then used to take off the substrate from the stamper 5, and vacuum tweezers or the like are then used to remove the thermoplastic resin substrate. Using this method, a fine channel substrate can be produced which contains orientation flats, concave portions that correspond with fine channels for flowing fluids, and through holes for either introducing or discharging fluids, wherein the concave portions corresponding with the fine channels and the through holes are interconnected. Examples of suitable thermoplastic resins include polycarbonates, polyetherimides, and polyacetals, and the actual resin used can be selected in accordance with the intended application. Any resin that can be subjected to injection molding can be used, and thermosetting resins such as epoxy resins are also suitable.

Next is a description of a method for producing a stamper 5 used for forming the concave portions that correspond with the fine channels for flowing fluids. A glass master that functions as a base substrate is first coated with a metal film of gold or the like, of sufficient thickness to prevent penetration of the exposure light described below, and a photoresist is then formed on top of the metal film. A photomask with a pattern that corresponds with the shape of the fine channels to be formed is then placed on top of the photoresist. Exposure is conducted from above the photomask, and the photoresist is then developed. Subsequently, the metal film is etched using acid or the like, the resist and the glass are then etched with hydrofluoric acid or the like, and the remaining metal film on the etching surface is then dissolved in acid or the like, thus yielding a glass master with a pattern that corresponds with the desired fine channels. Next, a technique such as sputtering is used to form a conductive metal thin film on the surface of the glass master that contains the concave portions corresponding with the fine channels, and an activation treatment is then performed to improve the adhesion between the conductive metal thin film and the subsequently formed electroformed metal layer, which is generated by a metal electroforming process. An electroformed metal layer is then formed by metal electroforming, and the conductive metal thin film and the electroformed metal layer are then separated from the glass master as a single integrated unit. By subsequently removing any residual resist, a stamper 5 containing convex portions that correspond with the desired fine channels can be obtained. This stamper 5 is then used as one of the components of one part (the movable mold 1a) of the two-part mold.

Next is a description of a method for producing a mold that includes the pins 6 for forming the through holes used for either introducing or discharging fluids. Holes for mounting the pins 6 used for forming through holes at predetermined locations within the fine channels are formed in the mold which is used for forming concave portions corresponding with the fine channels on the substrate surface which is opposite to the mold surface. The diameter of the holes is dependent on the diameter of the pins mounted within the holes, but preferably includes a tolerance that enables the pins 6 to be press fitted inside the holes. Pins 6 are then mounted in the mold containing these pin-mounting holes using a press fitting method. This mold containing the mounted pins 6 functions as the other part (the fixed mold 1b) of the two-part mold. The pins 6 mounted within the mold can be taken off if necessary. If pins 6 are removed from their holes, the empty holes are preferably plugged with dummy pins with a press fitting method. The length of the pins 6 used for forming the through holes in the fine channel substrate varies depending on the thickness of the fine channel substrate and the thickness of the ejector plate 7, but can be adjusted so that following mold clamping, the pins do not contact the surface of the opposing mold (the movable mold 1a), namely, the stamper 5 on which the convex portions corresponding with the fine channels are formed. The pins are preferably tapered only within those sections of the pins that correspond with the through holes (namely, only for the thickness of the fine channel substrate).

Next is a description of the ejector plate 7. When through holes are formed in an injection molded substrate, the injection molded substrate fails to separate from the mold on which the pins are mounted, and tends to remain stuck to the mold with the pins. In order to prevent this situation occurring, an ejector plate 7 is provided as a component of the mold that includes the pins 6 (the fixed mold 1b). This ejector plate 7 has holes in positions which correspond to the arrangement of the pins 6 and the mold including the pins 6 (the movable mold 1a), and the pins can slide through the ejector plate 7. This mold component exhibits a mechanism wherein, when the mold is opened, the ejector plate 7 pushes against the fine channel substrate containing the through holes, thereby simplifying the separation of the fine channel substrate from the mold (the fixed mold 1b) containing the pins 6.

As described above, a fine channel substrate of the present invention, which contains concave portions that correspond with fine channels for flowing fluids, and through holes for either introducing or discharging fluids, wherein the concave portions corresponding with the fine channels and the through holes are interconnected, can be produced using the configuration described below. Namely, by conducting injection molding using a stamper 5, which contains convex portions that correspond with the fine channels, as one component of one mold (the movable mold 1a), and also using a mold (the fixed mold 1b) that includes pins 6 for forming the through holes, and contains a mold component (the ejector plate 7) that includes holes for the pins 5 to slide through and functions as an ejector, a thermoplastic resin fine channel substrate can be produced which contains concave portions that correspond with the fine channels, and through holes, wherein the concave portions corresponding with the fine channels and the through holes are interconnected.

As follows is a specific example of the present invention. As mentioned above, it should be understood that this example is merely exemplary of the invention and is not to be considered as limiting. Various modifications can, of course, be made without departing from the scope of the present invention as defined in the claims.

### Example 1

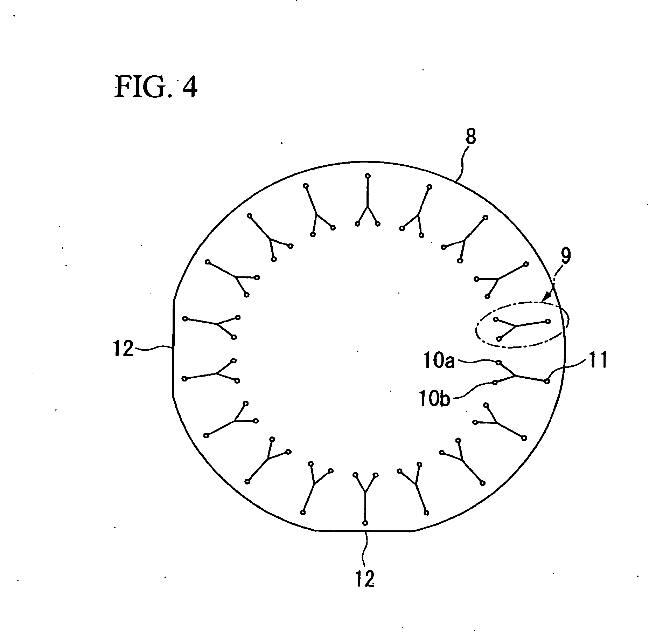

An example of the present invention is shown in FIG 4.

In a fine channel substrate 8 (external diameter φ = 140 mm, thickness t = 2.0 mm) were formed 18 Y-shaped fine channels, each containing concave portions (width W = 200 µm, depth (height) D = 100 µm) corresponding with fine channels 9 for flowing fluids. 54 through holes (diameter φ = 1.2 mm) that connected with the fine channels were formed as fluid inlet portions 10a, 10b or fluid discharge portions 11.

The mold used to form both the concave portions corresponding with the fine channels 9 and the through holes was as described below. A stamper 5 including convex portions corresponding with the fine channels 9 was mounted to the movable mold 1a of an injection molding device. The fixed mold 1b was equipped with pins 6 of external diameter φ = 1.2 mm for forming the 54 through holes in positions corresponding with the fluid inlet portions 10a, 10b, and the fluid discharge portions 11. In addition, an ejector plate 7, which contained 54 through holes of diameter φ = 1.2 mm at the same locations as the pins 6, and included sufficient tolerance to enable the pins to slide through these holes, was provided as one component of the fixed mold 1b, in order to enable the fine channel substrate to be more readily separated from the pins 6 used to form the through holes. Using these two molds, a fine channel substrate 8 containing concave portions corresponding with the fine channels 9, and through holes corresponding with either the fluid inlet portions 10a, 10b or the fluid discharge portions 11, wherein the concave portions corresponding with the fine channels 9 and the through holes were interconnected, was produced in a single operation by injection molding of a polycarbonate. When the mold was opened, the operation of the ejector plate 7 enabled the fine channel substrate to be separated favorably from the fixed mold 1b containing the pins 6 used for forming the 54 through holes. Two fine channel substrates 8 produced by injection molding in this manner were laminated together by heat fusion, and because the application of a compressive force during secondary clamping yielded a flat surface and very little dimensional variation as a result of heating, an extremely stable lamination of the fine channel substrates 8 was achieved. Moreover, because the fine channel substrates contained two orthogonal orientation flats, positional alignment during lamination was relatively simple.

As described above, according to the present invention, a fine channel substrate containing concave portions that correspond with fine channels for flowing fluids, and through holes for either introducing or discharging fluids, wherein the concave portions corresponding with the fine channels and the through holes are interconnected, can be produced from thermoplastic resin in a single operation. Moreover, by applying a secondary compression, a fine channel substrate 8 can be obtained in which the two surfaces are extremely flat, and the dimensional variations on heating are extremely small.

In the example above, a fine channel substrate of external diameter φ = 140 mm and thickness t = 2.0 mm, 18 Y-shaped fine channels, each containing concave portions of width W = 200 µm and depth D = 100 µm, and 54 through holes of diameter φ = 1.2 mm were formed by injection molding of a polycarbonate. However, in the present invention, the width and depth of the fine channels, the shape of the fine channels, the diameter of the through holes, and the level of integration of the fine channels are not limited to the above values. Needless to say, these conditions can be modified in accordance with factors such as the chemical reaction system being employed, or the particle size of the chromatography filler and the like being prepared. The resin used for forming the fine channel substrate 8 was a thermoplastic resin in the above example, but thermosetting resins can also be used.

The present invention provides a method for producing a fine channel substrate that includes concave portions corresponding with fine channels for flowing fluids, and through holes for either introducing or discharging fluids, wherein the concave portions corresponding with the fine channels and the through holes are interconnected

## Claims

1. A mo ld (1) for forming through holes (10a, 10b, 11) within a fine channel substrate (8) made of thermosetting resin or thermoplastic resin, and concave fine channels (9) in the surface of said fine channel substrate (8) in a single moulding operation, said through holes and said fine channels being interconnected, said mold comprising:
- a movable mold (1a) and a fixed mold (1b),
- a stamper (5) secured to the movable mold (1a) and comprising convex portions for forming said concave fine channels (9) on the surface of said fine channel substrate (8) by transfer under compressive force on the resin,
- holes formed at predetermined locations in the fixed mold (1b) and removable tapered pins (6) for forming through holes within a fine channel substrate, said tapered pins (6) being inserted within those holes that correspond with positions in which through holes (10a, 10b, 11) are to be formed,
- the length of the tapered pins (6) used for forming the through holes in the fine channel substrate (8) being adjusted so that, following mold clamping, the tapered pins (6) do contact the surface of the stamper (5),
**characterized in that**
- said mold further comprises a movable ejector plate (7) provided as a component of the fixed mould (1b) and having holes in positions corresponding with the locations of the tapered pins (6) so that said tapered pins (6) can slide through said holes of said ejector plate (7).

2. A mold (1), according to claim 1, wherein said fine channel (9) is a Y-shaped fine channel.

3. A mold (1), according to claim 1 or 2, wherein said ejector plate (7) comprises a mechanism wherein, when the mold (1) is opened, the ejector plate (7) pushes against the fine channel substrate (8) containing the through holes (10a, 10b, 11), thereby simplifying the separation of the fine channel substrate (8) from the fixed mold (1b) containing the tapered pins (6).

4. A mold (1), according to any preceding claims, further comprising dummy pins inserted in holes of the fixed mold (1b) that do not correspond with the position of a through hole (10a, 10b, 11) to be formed.

5. A method for producing through holes (10a, 10b, 11) within a fine channel substrate (8) made of thermosetting resin or thermoplastic resin and concave fine channel (9) in the surface of said fine channel substrate (8) in a single molding operation in a mold (1),
said mold (1) comprising:
- a cavity,
- a movable mold (1a) and a fixed mold (1b),
- a stamper (5) secured to the movable mold (1a) and comprising convex portions for forming said concave fine channels (9) on the surface of said fine channel substrate (8) by transfer under compressive force on the resin,
- holes formed at predetermined locations in the fixed mold (1b) and removable tapered pins (6) for forming through holes (10a, 10b, 11) within said fine channel substrate (9), said tapered pins (6) being inserted within those holes that correspond with positions in which through holes are to be formed,
wherein
- the length of the tapered pins (6) used for forming the through holes (10a, 10b, 11) in the fine channel substrate (8) being adjusted so that, following mold clamping, the tapered pins (6) do contact the surface of the stamper (5),
said method comprising:
o clamping the mold (1) at a position larger than the thickness of the fine channel substrate (8) to be produced,
o injecting melted resin into the cavity of the mold (1) through an injection nozzle (2), and filing the cavity with the injected resin,
o applying a compressive force to transfer the shape of the convex portions of the stamper (5) in the surface of said fine channel substrate (8) so as to create said concave fine channels (9), and to form said through holes (10a, 10b, 11);
o cooling the compressed resin to a curing temperature, and
o opening the mold (1),
**characterized in that**
said mold further comprises a movable ejector plate (7) provided as a component of the fixed mould (1b) and having holes in positions corresponding with the locations of the tapered pins (6) so that said tapered pins (6) can slide through said holes of said ejector plate (7)
and opening the mold (1) causes the ejector plate (7) to move, thereby pushing the resin off the
tapered pins (6) used to form the through holes and causing the resin to remain on the stamper (5).

6. A method according to claim 5, further comprising a step of taking off the substrate (8) from the stamper (5) with a spool cutting or an ejector pin.

7. A method according to any claim 5 to 6, wherein said fine channel (9) is a Y-shaped fine channel.

8. A method according to any claim 5 to 7, wherein said stamper (5) is produced according to the following steps:
- coating a glass master with a metal film,
- forming a photoresist on top of said metal film,
- placing on top of said photoresist a photomask with a pattern that corresponds with the shape of the fine channels (9) to be formed,
- exposing said photomask and developing said photoresist,
- etching said metal film, the photoresist and the glass with acid,
- dissolving remaining metal film on etching surface in acid, yielding to a glass master with a pattern that corresponds with desired fine channels.

9. A method according to claim 7, further comprising the steps of
- forming a conductive metal film on the surface of the glass master,
- performing an activation treatment to improve the adhesion between the conductive metal film and the subsequently formed electroformed metal layer, which is generated by a metal electroforming process,
- forming then an electroformed metal layer by metal electroforming, and
- separating the conductive metal film and the electro formed metal layer from the glass master.

10. A method according to claim 9, further comprising the step of subsequently removing any residual resist.

## Patentansprüche

1. Form (1) zum Bilden von Durchgangslöchern (10a, 10b, 11) innerhalb eines Substrats (8) mit feinen Kanälen, das aus einem duroplastischen Harz oder thermoplastischen Harz hergestellt ist, und konkaven feinen Kanälen (9) in der Oberfläche des feinkanaligen Substrats (8) in einem einzigen Vorgang, wobei die Durchgangslöcher und die feinen Kanäle untereinander verbunden sind, wobei die Form aufweist:
- eine bewegliche Form (1a) und eine fixierte Form (1b),
- einen Stempel (5), der in der beweglichen Form (1a) befestigt ist und konvexe Bereiche zum Formen der konkaven feinen Kanäle (9) auf der Oberfläche des feinkanaligen Substrats (8) durch Übertragung unter Druckkraft auf das Harz aufweist,
- Löcher, die an vorbestimmten Stellen in der fixierten Form (1b) ausgebildet sind und entfernbare spitze Stifte (6) zum Bilden der Durchgangslöcher innerhalb eines feinkanaligen Substrats, wobei die spitzen Stifte (6) in solche Löcher eingesetzt werden, die mit Positionen korrespondieren, in welchen Durchgangslöcher (10a, 10b, 11) ausgebildet werden sollen,
- wobei die Länge der spitzen Stifte (6), die zum Bilden der Durchgangslöcher in dem feinkanaligen Substrat (8) verwendet werden, so eingestellt ist, dass nach dem Spannen der Form die spitzen Stifte (6) die Oberfläche des Stempels (5) berühren, **dadurch gekennzeichnet, dass**
- die Form ferner eine bewegliche Ausstoßplatte (7) aufweist, die als eine Komponente der fixierten Form (1b) vorgesehen ist und Löcher in Positionen hat, die mit den Stellen der spitzen Stifte (6) korrespondieren, so dass die spitzen Stifte (6) durch die Löcher der Ausstoßplatte (7) hindurch gleiten können.

2. Form (1) nach Anspruch 1, in welcher der feine Kanal (9) ein Y-förmiger feiner Kanal ist.

3. Form (1) nach Anspruch 1 oder 2, in welcher die Ausstoßplatte (7) einen Mechanismus umfasst, in welchem die Ausstoßplatte (7), wenn die Form (1) geöffnet wird, gegen das feinkanalige Substrat (8) drückt, welches die Durchgangslöcher (10a, 10b, 11) enthält, wodurch die Trennung des feinkanaligen Substrats (8) von der fixierten Form (1b) mit den spitzen Stiften (6) vereinfacht wird.

4. Form (1) nach einem der vorhergehenden Ansprüche, ferner mit Platzhalterstiften, die in Löcher der fixierten Form (1b) eingeführt sind, die nicht mit der Position des zu formenden Durchgangsloches (10a, 10b, 11) korrespondieren.

5. Verfahren zum Herstellen von Durchgangslöchern (10a, 10b, 11) innerhalb eines feinkanaligen Substrats (8) aus duroplastischem Harz oder thermoplastischem Harz und einem konkaven feinen Kanal (9) in der Oberfläche des feinkanaligen Substrats (8) in einem einzigen Formvorgang in einer Form (1),
wobei die Form (1) umfasst:
- einen Hohlraum,
- eine bewegliche Form (1a) und eine fixierte Form (1b),
- einen Stempel (5), der in der beweglichen Form (1a) befestigt ist und konvexe Bereiche zum Formen der konkaven feinen Kanäle (9) auf der Oberfläche des feinkanaligen Substrats (8) durch Übertragung unter Druckkraft auf das Harz umfasst,
- Löcher, die an vorbestimmten Stellen in der fixierten Form (1b) ausgebildet sind, und entfernbare spitze Stifte (6) zum Formen der Durchgangslöcher (10a, 10b, 11) innerhalb des feinkanaligen Substrats (9), wobei die spitzen Stifte (6) in solche Löcher eingeführt werden, die mit Positionen korrespondieren, in welchen Durchgangslöcher ausgebildet werden sollen,
wobei
- die Länge der spitzen Stifte (6), die zum Bilden der Durchgangslöcher (10a, 10b, 11) in dem feinkanaligen Substrat (8) verwendet werden, so eingestellt ist, dass nach dem Spannen der Form die spitzen Stifte (6) die Oberfläche des Stempels (5) berühren,
wobei das Verfahren umfasst:
○ Spannen der Form (1) in einer Position, die größer ist als die Dicke des herzustellenden feinkanaligen Substrats (8),
○ Injizieren von geschmolzenem Harz in den Hohlraum der Form (1) durch eine Injektionsdüse (2), und Füllen des Hohlraums mit dem in- jizierten Harz,
○ Aufbringen einer Druckkraft, um die Form der konvexen Bereiche des Stempels (5) in die Oberfläche des feinkanaligen Substrats (8) zu übertragen, um so die konkaven feinen Kanäle (9) zu erzeugen und die Durchgangslöcher (10a, 10b, 11) zu bilden;
○ Kühlen des komprimierten Harzes auf eine Aushärttemperatur, und
○ Öffnen der Form (1),
**dadurch gekennzeichnet, dass**
- die Form ferner eine bewegliche Ausstoßplatte (7) umfasst, die als eine Komponente der fixierten Form (1b) vorgesehen ist, und Löcher in Positionen aufweist, die mit den Stellen der spitzen Stifte (6) korrespondieren, so dass die spitzen Stifte (6) durch die Löcher der Ausstoßplatte (7) hindurch gleiten können und ein Öffnen der Form (1) die Ausstoßplatte (7) veranlasst, sich zu bewegen und **dadurch** das Harz von den spitzen Stiften (6), die zum Formen der Durchgangslöcher verwendet werden, wegzudrücken und das Harz zu veranlassen, auf dem Stempel (5) zu verbleiben.

6. Verfahren nach Anspruch 5, ferner mit einem Schritt des Abnehmens des Substrats (8) vom Stempel (5) mit einem Rollenschneidvorgang oder einem Auswerf stift.

7. Verfahren nach Anspruch 5 oder 6, in welchem der feine Kanal ein Y-förmiger feiner Kanal ist.

8. Verfahren nach einem der Ansprüche 5 bis 7, in welchem der Stempel (5) gemäß den folgenden Schritten hergestellt wird:
- Beschichten eines Glasmasters mit einem Metallfilm,
- Formen eines Fotolacks auf der Oberseite des Metallfilms,
- Platzieren einer Fotomaske mit einem Muster auf die Oberseite des Fotolacks, das mit der Form der zu formenden feinen Kanäle (9) korrespondiert,
- Belichten der Fotomaske und Entwickeln des Fotolacks,
- Ätzen des Metallfilms, des Fotolacks und des Glases mit Säure,
- Lösen des verbleibenden Metallfilms auf der Ätzfläche in Säure, das einen Glasmaster mit einem Muster ergibt, das mit den gewünschten feinen Kanälen korrespondiert.

9. Verfahren nach Anspruch 7, ferner mit den Schritten:
- Formen eines leitfähigen Metallfilms auf der Oberfläche des Glasmasters,
- Durchführen einer Aktivierungsbehandlung, um die Haftung zwischen dem leitfähigen Metallfilm und der nachfolgend gebildeten galvanisch geformten Metallschicht zu verbessern, die durch ein galvanisches Metallformungsverfahren erzeugt wird,
- dann Bilden einer galvanisch geformten Metallschicht durch eine galvanische Metallformung und
- Trennen des leitfähigen Metallfilms und der galvanisch geformten Metallschicht von dem Glasmaster.

10. Verfahren nach Anspruch 9, ferner mit dem Schritt, eines nachfolgenden Entfernens von restlichem Lack.

## Revendications

1. Moule (1) permettant de former des trous débouchants (10a, 10b, 6) dans un substrat (8) à canaux fins réalisé en résine thermodurcissable ou en résine thermoplastique, et des canaux fins concaves (9) à la surface dudit substrat à canaux fins (8) en une seule opération de moulage, lesdits trous débouchants et lesdits canaux fins étant reliés entre eux, ledit moule comprenant
un moule mobile (1a) et un moule fixe (1b),
un poinçon (5) solidaire du moule mobile (1a) et comprenant des parties convexes destinées à former lesdits canaux fins concaves (9) sur la surface dudit substrat à canaux fins (8) par transfert sous une force de compression sur la résine,
des trous formés au niveau d'emplacements prédéterminés dans le moule fixe (1b) et des tiges coniques amovibles (6) permettant de former des trous débouchants dans un substrat à canaux fins, lesdites tiges coniques (6) étant insérées dans les trous qui correspondent aux positions dans lesquelles des trous débouchants (10a, 10b, 11) vont être formés,
la longueur des tiges coniques (6) utilisées pour former les trous débouchants dans le substrat à canaux fins (8) étant ajustée pour que, après le serrage du moule, les tiges coniques (6) rentrent en contact avec la surface du poinçon (5),
**caractérisé en ce que**
ledit moule comprend en outre une plaque d'éjection mobile (7) fournie en tant que composant du moule fixe (1b) et comprenant des trous dans des positions qui correspondent aux emplacements des tiges coniques (6) de sorte que lesdites tiges coniques (6) puissent glisser à travers lesdits trous de ladite plaque d'éjection (7).

2. Moule (1), selon la revendication 1, dans lequel ledit canal fin (9) est un canal fin en forme de Y.

3. Moule (1), selon la revendication 1 ou 2, dans lequel ladite plaque d'éjection (7) comprend un mécanisme dans lequel, lorsque le moule (1) est ouvert, la plaque d'éjection (7) appuie contre le substrat à canaux fins (8) comprenant les trous débouchants (10a, 10b, 11), ce qui simplifie la séparation du substrat à canaux fins (8) du moule fixe (1b) comprenant les tiges coniques (6).

4. Moule (1), selon l'une des revendications précédentes, comprenant en outre des tiges factices insérées dans les trous du moule fixe (1b) qui ne correspondent pas à la position d'un trou débouchant (10a, 10b, 11) devant être formé.

5. Procédé destiné à produire des trous débouchants (10a, 10b, 11) dans un substrat à canaux fins (8) réalisé en résine thermodurcissable ou en résine thermoplastique et un canal fin concave (9) à la surface dudit substrat à canaux fins (8) en une seule opération de moulage dans un moule (1),
ledit moule (1) comprenant :
une cavité,
un moule mobile (1a) et un moule fixe (1b),
un poinçon (5) solidaire du moule mobile (1a) et comprenant des parties convexes destinées à former lesdits canaux fins concaves (9) sur la surface dudit substrat à canaux fins (8) par transfert sous une force de compression sur la résine,
des trous formés à des emplacements prédéterminés dans le moule fixe (1b) et des tiges coniques amovibles (6) pour former des trous débouchants (10a, 10b, 11) dans ledit substrat à canaux fins (9), lesdites tiges coniques (6) étant insérées dans les trous qui correspondent aux positions dans lesquelles des trous débouchants vont être formés,
dans lequel
la longueur des tiges coniques (6) utilisées pour former les trous débouchants (10a, 10b, 11) dans le substrat à canaux fins (8) est ajustée de sorte qu'après le serrage du moule, les tiges coniques (6) ne rentrent pas en contact avec la surface du poinçon (5), ledit procédé comprenant le fait :
de serrer le moule (1) dans une position supérieure à l'épaisseur du substrat à canaux fins (8) à produire,
d'injecter de la résine fondue dans la cavité du moule (1) à travers une buse d'injection (2), et de remplir la cavité avec la résine injectée,
d'appliquer une force de compression pour transférer la forme des parties convexes du poinçon (5) à la surface dudit substrat à canaux fins (8) de manière à créer lesdits canaux fins concaves (9), et pour former lesdits trous débouchants (10a, 10b, 11) ;
de refroidir la résine comprimée à une température de durcissement, et
d'ouvrir le moule (1),
**caractérisé en ce que**
ledit moule comprend en outre une plaque (7) d'éjection mobile fournie en tant que composant du moule fixe (1b) et comprenant des trous dans des positions qui correspondent aux emplacements des tiges coniques (6) de sorte que lesdites tiges coniques (6) puissent glisser à travers lesdits trous de ladite plaque d'éjection (7),
et l'ouverture du moule (1) amène la plaque d'éjection (7) à se déplacer, éjectant ainsi la résine des tiges coniques (6) utilisées pour former les trous débouchants et amenant la résine à rester sur le poinçon (5).

6. Procédé selon la revendication 5, comprenant en outre une étape qui consiste à retirer le substrat (8) du poinçon (5) par coupe bobine ou à l'aide d'un éjecteur.

7. Procédé selon l'une des revendications 5 à 6, dans lequel ledit canal fin (9) est un canal fin en forme de Y.

8. Procédé selon l'une des revendications 5 à 7, dans lequel ledit poinçon (5) est produit selon les étapes qui consistent :
à revêtir une vitre maîtresse avec un film métallique,
à former une réserve photosensible sur le dessus dudit film métallique,
à placer sur le dessus de ladite résine photosensible un masque photographique avec un motif qui correspond à la forme des canaux fins (9) à former,
à exposer ledit masque photographique et à développer ladite résine photosensible,
à décaper ledit film métallique, la résine photosensible et la vitre avec de l'acide,
à dissoudre le film métallique restant sur la surface de décapage dans l'acide, aboutissant à une vitre maîtresse avec un motif qui correspond à des canaux fins souhaités.

9. Procédé selon la revendication 7, comprenant en outre les étapes qui consistent :
à former un film métallique conducteur sur la surface de la vitre maîtresse,
à effectuer un traitement d'activation afin d'améliorer l'adhérence entre le film métallique conducteur et la couche métallique électro-formée qui est formée postérieurement, qui est générée par un processus d'électroformage de métaux,
à former ensuite une couche métallique électro-formée par du métal électro-formée par électroformage de métal, et
à séparer le film métallique conducteur et la couche métallique électro-formée de la vitre maîtresse.

10. Procédé selon la revendication 9, comprenant en outre l'étape qui consiste à enlever par la suite toute réserve résiduelle.
